# EUROPEAN PATENT SPECIFICATION

(11) **EP 3 576 081 B1**
(45) Date of publication and mention of the grant of the patent: **28.08.2024**
(21) Application number: 19177148.4
(22) Date of filing: 29.05.2019
(51) Int. Cl.: G09G 3/3233

(54) **PIXEL CIRCUITS FOR LIGHT EMITTING ELEMENTS**
PIXELSCHALTUNGEN FÜR LICHTEMITTIERENDE ELEMENTE
CIRCUITS DE PIXEL POUR ÉLÉMENTS ÉLECTROLUMINESCENTS

(30) Priority: 30.05.2018 US 201815992180
(43) Date of publication of application: 04.12.2019
(73) Proprietor: Kunshan Yunyinggu Electronic Technology Co., Ltd., Kunshan Development Zone Kunshan Jiangsu (CN)
(72) Inventor: Peng, Yu-Hsun, Shanghai, 200437 (CN); Chang, Yu-Kuang, Shanghai, 200437 (CN); Su, Chao-Wei, Shanghai, 200437 (CN); Huang, Chun-Wei, Shanghai, 200437 (CN)
(74) Representative: Müller-Boré & Partner Patentanwälte PartG mbB

(56) References cited:
- US-A1- 2013 026 929
- US-A1- 2013 088 416

## Description

### BACKGROUND

The disclosure relates generally to display technologies, and more particularly, to a light emitting display device.

Emerging applications of display technologies, such as head-mounted displays (HMDs) for virtual reality (VR), augmented reality (AR), and mixed reality (MR), oftentimes have strict requirements for display quality. For example, HMDs usually require high frame rate and low latency in order to respond immediately to users' movement with updated display images, thereby providing immersion experience and preventing cybersickness, motion blur, and image broken. Moreover, high brightness, high contrast ratio, high motion contrast, and high resolution are also important specifications for HMDs. For example, high contrast ratio is important for nighttime applications in the dark environment, and high brightness is important for outdoor applications in strong ambient light.

US 2013/088416 A1 describes a method of driving an OLED display, wherein the OLED display comprises a plurality of pixel driver circuits on chiplets, each pixel driver circuit comprising an output transistor for driving a first connection of an associated OLED pixel.

US 2013/026929 A1 describes a micro display which is applied to a head mounted display to display an image.

### SUMMARY

The problem to provide pixel circuits for light emitting elements with improved display specifications is solved by the independent claim. Preferred embodiments are defined in the dependent claims. Embodiments of pixel circuits for light emitting elements are disclosed herein.

### BRIEF DESCRIPTION OF THE DRAWINGS

The accompanying drawings, which are incorporated herein and form part of the specification, illustrate the presented disclosure and, together with the description, further serve to explain the principles of the disclosure and enable a person of skill in the relevant art(s) to make and use the disclosure.
FIG. 1 is a block diagram illustrating an apparatus including a display and control logic in accordance with an embodiment.
FIG. 2 is a block diagram illustrating the display shown in FIG. 1 including driving circuits in accordance with an embodiment.
FIG. 3 is a circuit diagram of a pixel circuit for driving a light emitting element.
FIG. 4 is a circuit diagram of another pixel circuit for a light emitting element.
FIG. 5 is a circuit diagram of an exemplary circuit having global emission control for driving a plurality of light emitting elements in accordance with an embodiment, which is not part of the invention.
FIG. 6 is a circuit diagram of an exemplary circuit having global emission/discharge control for driving a plurality of light emitting elements in accordance with an embodiment, which is not part of the invention.
FIGs. 7A and 7B are circuit diagrams of pixel circuits for driving a light emitting element.
FIG. 8 is a circuit diagram of an exemplary pixel circuit having a bridge transistor for driving a light emitting element in accordance with an embodiment, which is not part of the invention.
FIG. 9 is a circuit diagram of another exemplary pixel circuit having a bridge transistor for driving a light emitting element in accordance with an embodiment, which is not part of the invention.
FIG. 10A is a circuit diagram of still another exemplary pixel circuit having a bridge transistor for driving a light emitting element in accordance with an embodiment of the invention.
FIG. 10B is a circuit diagram of yet another exemplary pixel circuit having a bridge transistor for driving a light emitting element in accordance with an embodiment of the invention.
FIG. 11 is a circuit diagram of an exemplary circuit having global emission/discharge control and bridge transistors for driving light emitting elements in accordance with an embodiment of the invention.
FIG. 12 is a circuit diagram of another exemplary circuit having global emission/discharge control and bridge transistors for driving light emitting elements in accordance with an embodiment of the invention.

The presented disclosure is described with reference to the accompanying drawings. In the drawings, generally, like reference numbers indicate identical or functionally similar elements. Additionally, generally, the left-most digit(s) of a reference number identifies the drawing in which the reference number first appears.

### DETAILED DESCRIPTION

Although specific configurations and arrangements are discussed, it should be understood that this is done for illustrative purposes only. It is contemplated that other configurations and arrangements can be used without departing from the spirit and scope of the present disclosure. It is further contemplated that the present disclosure can also be employed in a variety of other applications.

It is noted that references in the specification to "one embodiment," "an embodiment," "an example embodiment," "some embodiments," etc., indicate that the embodiment described may include a particular feature, structure, or characteristic, but every embodiment may not necessarily include the particular feature, structure, or characteristic. Moreover, such phrases do not necessarily refer to the same embodiment. Further, when a particular feature, structure or characteristic is described in connection with an embodiment, it is contemplated that such feature, structure or characteristic may also be used in connection with other embodiments whether or not explicitly described.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

As will be disclosed in detail below, among other novel features, the pixel circuits for light emitting elements, such as organic light emitting elements (OLEDs) and micro-LEDs, disclosed herein can improve a variety of display specifications. In some embodiments, the pixel circuits having global emission and discharge control for multiple light emitting elements can reduce display motion blur and increase the granularity of brightness control without significantly increasing the area of the pixel circuits. In some embodiments, the pixel circuits having isolation devices (e.g., bridge transistors) for voltage boosting can increase the withstand voltage of pixel drivers and avoid junction break-down, thereby increasing the driving voltage, contrast ratio, and display resolution of HMDs.

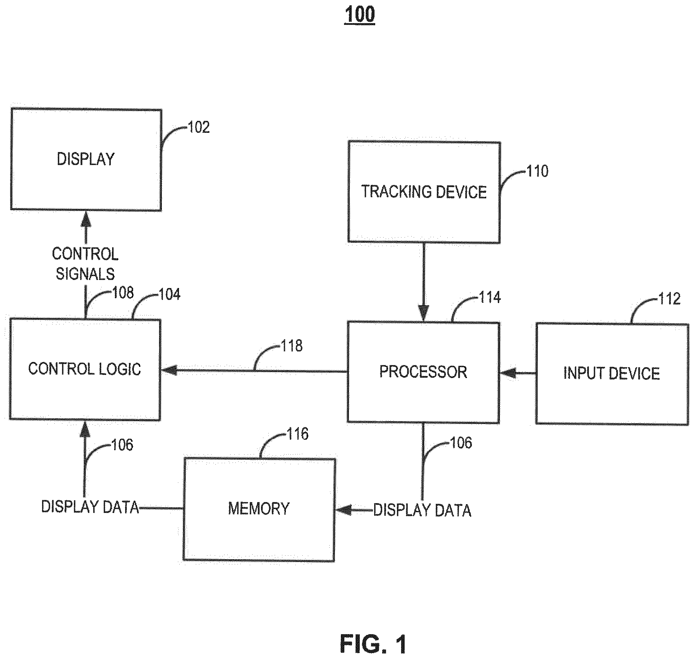

FIG. 1 illustrates an apparatus 100 including a display 102 and control logic 104. Apparatus 100 may be any suitable device, for example, a VR, AR, or MR device (e.g., VR headset, etc.), handheld device (e.g., dumb or smart phone, tablet, etc.), wearable device (e.g., eyeglasses, wrist watch, etc.), automobile control station, gaming console, television set, laptop computer, desktop computer, netbook computer, media center, set-top box, global positioning system (GPS), electronic billboard, electronic sign, printer, or any other suitable device. In this embodiment, display 102 is operatively coupled to control logic 104 and is part of apparatus 100, such as but not limited to, an HMD, handheld device screen, computer monitor, television screen, dashboard, electronic billboard, or electronic sign. Display 102 may be an OLED display, micro-LED display, liquid crystal display (LCD), E-ink display, electroluminescent display (ELD), billboard display with LED or incandescent lamps, or any other suitable type of display.

Control logic 104 may be any suitable hardware, software, firmware, or combination thereof, configured to receive display data 106 (e.g., pixel data) and generate control signals 108 for driving the subpixels on display 102. Control signals 108 are used for controlling writing of display data 106 to the subpixels and directing operations of display 102. For example, subpixel rendering (SPR) algorithms for various subpixel arrangements may be part of control logic 104 or implemented by control logic 104. Control logic 104 may be implemented as a standalone integrated circuit (IC) chip, such as an application-specific integrated circuit (ASIC) or a field-programmable gate array (FPGA). Apparatus 100 may also include any other suitable components, such as, but not limited to tracking devices 110 (e.g., inertial sensors, camera, eye tracker, GPS receiver, or any other suitable devices for tracking motion of eyeballs, facial expression, head movement, body movement, and hand gesture), input devices 112 (e.g., a mouse, keyboard, remote controller, handwriting device, microphone, scanner, etc.), and speakers (not shown).

In this embodiment, apparatus 100 may be a handheld or a VR/AR/MR device, such as a smart phone, a tablet, or a VR headset. Apparatus 100 may also include a processor 114 and memory 116. Processor 114 may be, for example, a graphics processor (e.g., graphics processing unit (GPU)), an application processor (AP), a general processor (e.g., APU, accelerated processing unit; GPGPU, general-purpose computing on GPU), or any other suitable processor. Memory 116 may be, for example, a discrete frame buffer or a unified memory. Processor 114 is configured to generate display data 106 in display frames and may temporally store display data 106 in memory 116 before sending it to control logic 104. Processor 114 may also generate other data, such as but not limited to, control instructions 118 or test signals, and provide them to control logic 104 directly or through memory 116. Control logic 104 then receives display data 106 from memory 116 or from processor 114 directly.

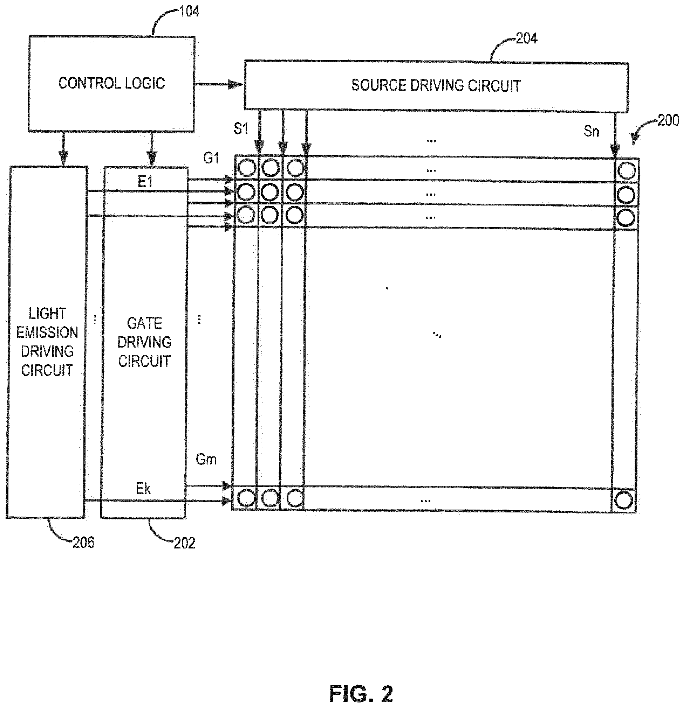

FIG. 2 is a block diagram illustrating display 102 shown in FIG. 1 including driving circuits in accordance with an embodiment. Display 102 in this embodiment includes a display panel having an active region 200 including a plurality of subpixels. The display panel may also include on-panel driving circuits, e.g., a gate driving circuit 202 and a source driving circuit 204. It is to be appreciated that in some embodiments, gate driving circuit 202 and source driving circuit 204 may not be on-panel driving circuits, i.e., not parts of the display panel, but instead are operatively coupled to the display panel.

Each subpixel may be any of the units that make up a pixel, i.e., a subdivision of a pixel. For example, a subpixel may be a single-color display element that can be individually addressed. In some embodiments in which display 102 is a light emitting element display (e.g., an OLED display or a micro-LED display), each subpixel may include a light emitting element (e.g., an OLED or a micro-LED) and a pixel circuit for driving the light emitting element. The plurality of subpixels (and the light emitting elements thereof) may be arranged in an array having a plurality of rows and columns according to any suitable subpixel arrangement. Each light emitting element can emit light in a predetermined brightness and color, such as but not limited to, red, green, blue, yellow, cyan, magenta, or white. Each pixel circuit includes thin film transistors (TFTs) and capacitor(s) and is configured to drive the corresponding subpixel by controlling the light emitting from the respective light emitting element according to control signals 108 from control logic 104. The pixel circuit may be in a 2T1C configuration (i.e., including a switching transistor, a driving transistor, and a storage capacitor) or may include a compensation circuit with more transistors and/or capacitors for brightness uniformity, such as in a 7T1C, 5T1C, 5T2C, or 6T1C configuration.

Gate driving circuit 202 in this embodiment is operatively coupled to active region 200 via a plurality of gate lines G1-Gm (a.k.a. scan lines) and configured to scan the plurality of subpixels. For example, gate driving circuit 202 applies a plurality of scan signals, which are generated based on control signals 108 from control logic 104, to the plurality of gate lines G1-Gm for scanning the plurality of subpixels in a gate scanning order. A scan signal is applied to the gate electrode of a switching transistor of each pixel circuit during the scan period to turn on the switching transistor so that the data signal for the corresponding subpixel can be written by source driving circuit 204. It is to be appreciated that although one gate driving circuit 202 is illustrated in FIG. 2, in some embodiments, multiple gate driving circuits may work in conjunction with each other to scan the subpixels.

Source driving circuit 204 in this embodiment is operatively coupled to active region 200 via a plurality of source lines S1-Sn (a.k.a. data lines) and configured to write display data 106 in frames to the plurality of subpixels. For example, source driving circuit 204 may simultaneously apply a plurality of data signals to the plurality of source lines S1-Sn for the subpixels. That is, source driving circuit 204 may include one or more shift registers, digital-analog converters (DAC), multiplexers (MUX), and arithmetic circuit for controlling a timing of application of voltage to the source electrode of the switching transistor of each pixel circuit (i.e., during the scan period in each frame) and a magnitude of the applied voltage according to gradations of display data 106. It is to be appreciated that although one source driving circuit 204 is illustrated in FIG. 2, in some embodiments, multiple source driving circuits may work in conjunction with each other to apply the data signals to the source lines for the subpixels.

Additionally, a light emission driving circuit 206 may be included on the display panel. Light emission driving circuit 206 may be operatively coupled to active region 200 and configured to cause each subpixel to emit light for a certain time period in each frame by applying a plurality of light emission signals to a plurality of emission lines E1-Ek. It is to be appreciated that although one light emission driving circuit 206 is illustrated in FIG. 2, in some embodiments, multiple light emission driving circuits may work in conjunction with each other.

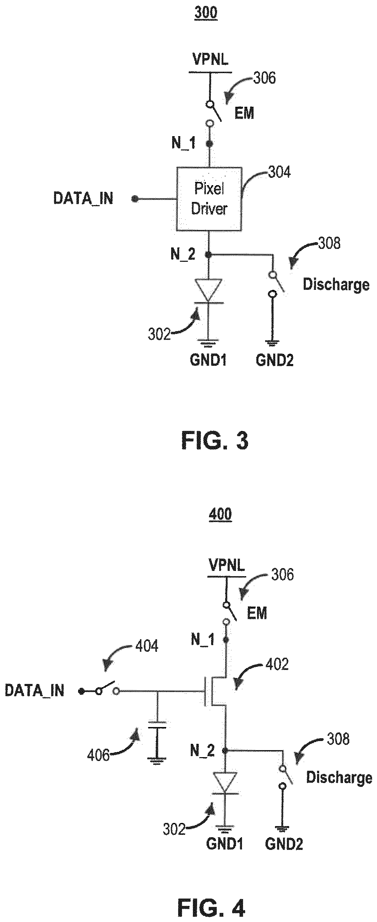

FIG. 3 is a circuit diagram of a pixel circuit 300 for driving a light emitting element 302. Light emitting element 302 may be an OLED or a micro-OLED driven by pixel circuit 300. Pixel circuit 300 includes a pixel driver 304 configured to receive a data signal DATA_IN and drive light emitting element 302 based on the data signal. Pixel circuit 300 also includes a light emission control switch EM 306 coupled to pixel driver 304 (at node N_1) and a power source VPNL. Light emission control switch 306 may control light emission of light emitting element 302 in each frame. Pixel circuit 300 further includes a discharge control switch 308 coupled to pixel driver 304 (at node N_2) and a ground GND2. Discharge control switch 308 may control the discharge of light emitting element 302. By applying an emission signal and a discharge signal in appropriate waveforms and timings to light emission control switch 306 and discharge control switch 308, respectively, pixel circuit 300 can achieve fine brightness control of light emitting element 302 and reduce display motion blur. For example, Table 1 below illustrates one example of emission/discharge control schemes applicable to pixel circuit 300:

**Table 1**

| **Subpixel Status** | **EM** | **N_1** | **DATA_IN** | **Discharge** | **N_2** | **Light Emitting Element** | **Note** |
|---|---|---|---|---|---|---|---|
| ON | ON | VPNL | Gray-code | OFF | Gray-voltage | Gray-level | Normal display |
| OFF1 | OFF | Hi-Z | Gray-code | OFF | Hi-Z | OFF | Emission off, light emitting element self-discharge |
| OFF2 | OFF | Hi-Z | Gray-code | ON | GND2 | OFF | Emission off, external-discharge |
| Disable | OFF | Hi-Z | Disable | ON | GND2 | OFF | Subpixel turn-off |

FIG. 4 is a circuit diagram of another pixel circuit 400 for light emitting element 302. Pixel circuit 400 is similar to pixel circuit 300 except for the implementation detail of pixel driver 304. In pixel circuit 400, the pixel driver includes an n-type driving transistor 402, a switch 404 (e.g., a switching transistor), and a capacitor 406 (e.g., a storage capacitor). Table 2 below illustrates one example of emission/discharge control schemes applicable to pixel circuit 400:

**Table 2**

| **Subpixel Status** | **EM** | **N_1** | **DATA_IN** | **Discharge** | **N_2** | **Light Emitting Element** | **Note** |
|---|---|---|---|---|---|---|---|
| ON | ON | VPNL | Gray-code | OFF | Gray-voltage | Gray-level | Normal display |
| OFF1 | OFF | Hi-Z | Gray-code | OFF | Hi-Z | OFF | Emission off, light emitting element self-discharge |
| OFF2 | OFF | GND2 | Gray-code | ON | GND2 | OFF | Emission off, external-discharge |
| Disable | OFF | GND2 | Disable | ON | GND2 | OFF | Subpixel turn-off |

For each light emitting element 302, pixel circuit 300 or 400 needs to include an individual set of light emission control switch 306 and discharge control switch 308, each of which may include multiple devices (e.g., transistors). Thus, the total area of pixel circuits for the array of subpixels may be significantly increased, thereby reducing the display resolution.

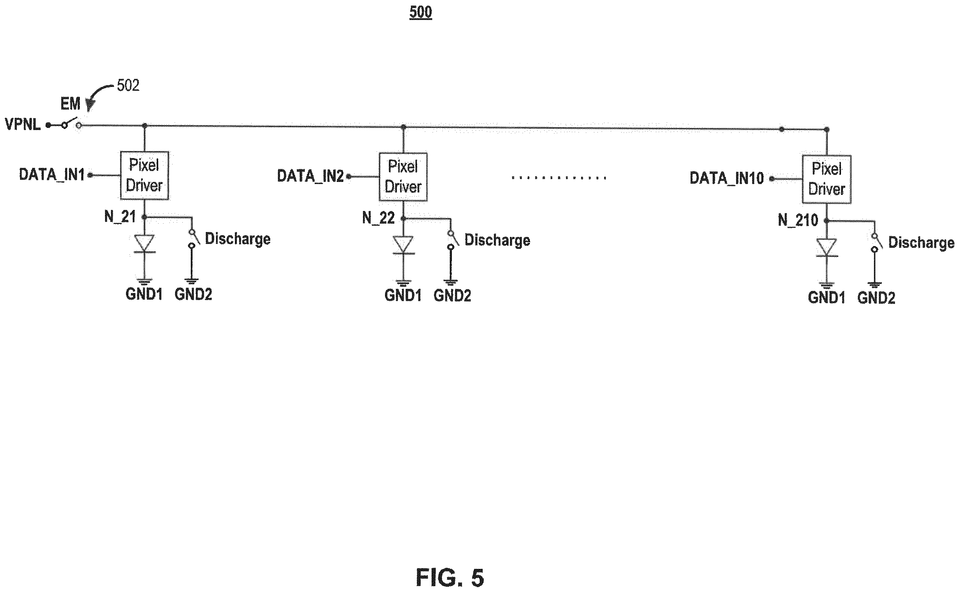

FIG. 5 is a circuit diagram of an exemplary circuit 500 having global emission control for driving a plurality of light emitting elements in accordance with an embodiment. In this embodiment, the plurality of light emitting elements may be arranged in the same row. That is, the plurality of light emitting elements may receive the same scan signal via the same gate line from gate driving circuit 202. Each light emitting element is driven by its own pixel driver based on a respective data signal (DATA_IN1, DATA_IN2, ...) and discharged by its own discharge control switch. Instead of having an individual emission control switch for each light emitting element, circuit 500 includes a global light emission controller 502 coupled to a power source VPNL and the pixel drivers of each light emitting element. Global light emission controller 502 is configured to, in response to a global light emission signal, simultaneously control light emission of the plurality of light emitting elements in the same row. The light emission signal may be provided via a corresponding emission line from light emission driving circuit 206. In some embodiments, the number of devices (e.g., transistors) in light emission controller 502 may be the same as that in each individual light emission control switch 306. Thus, by replacing mutiple emission control switches with a single global light emission controller 502 for controlling light emission of multiple light emitting elements, the total area of pixel circuits for the array of subpixels can be reduced, thereby increasing the display resolution.

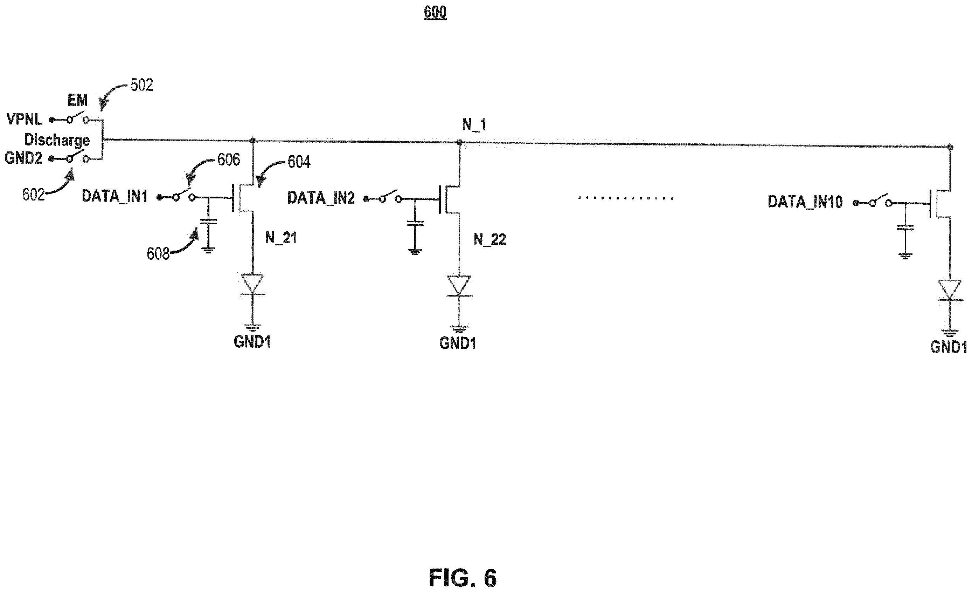

FIG. 6 is a circuit diagram of an exemplary circuit 600 having global emission/discharge control for driving a plurality of light emitting elements in accordance with an embodiment. In addition to achieving global emission control using light emission controller 502, circuit 600 can further achieve global discharge control using a global discharge controller 602 coupled to the pixel drivers (at common node N_1) of each light emitting element and a ground GND2. Discharge controller 602 is configured to, in response to a global discharge signal, simultaneously control discharge of the plurality of light emitting elements in the same row.

As shown in FIG. 6, each light emitting element is driven by a respective pixel circuit including a pixel driver. The pixel driver includes a driving transistor 604 (e.g., an n-type transistor or a p-type transistor) having a source terminal and a drain terminal. One of the source and drain terminals of driving transistor 604 may be coupled to light emission controller 502 and discharge controller 602 (at common node N_1) depending on whether driving transistor 604 is a n-type transistor or a p-type transistor. The other one of the source and drain terminals of driving transistor 604 may be coupled to the respective light emitting element (at respective node N_21, N22, ...). The pixel driver also includes a switch 606 and a capacitor 608 both coupled to a gate terminal of driving transistor 604. Switch 606 may include one or more transistors (e.g., a switching transistor) configured to, in response to a scan signal, charge capacitor 608 to a voltage based on the respective data signal (DATA_IN1, DATA_IN2, ...), so that the gate terminal of driving transistor 604 is biased based on the voltage charged to capacitor 608. In this embodiment, the switches of each pixel driver receive the same scan signal via the same gate line from gate driving circuit 202 as the light emitting elements are arranged in the same row. Table 3 below illustrates one example of global emission/discharge control schemes applicable to circuit 600:

**Table 3**

| **Subpixel Status** | **EM** | **N_1** | **DATA_IN** | **N_2** | **Light Emitting Element** | **Note** |
|---|---|---|---|---|---|---|
| ON | ON | VPNL | Gray-code | Gray-voltage | Gray-level | Normal display |
| OFF1 | OFF | Hi-Z | Gray-code | Hi-Z | OFF | Emission off, light emitting element self-discharge |
| OFF2 | OFF | GND2 | Gray-code | GND2 | OFF | Emission off, external-discharge |
| Disable | OFF | GND2 | Disable | GND1<V<GND2 | OFF | Subpixel turn-off |

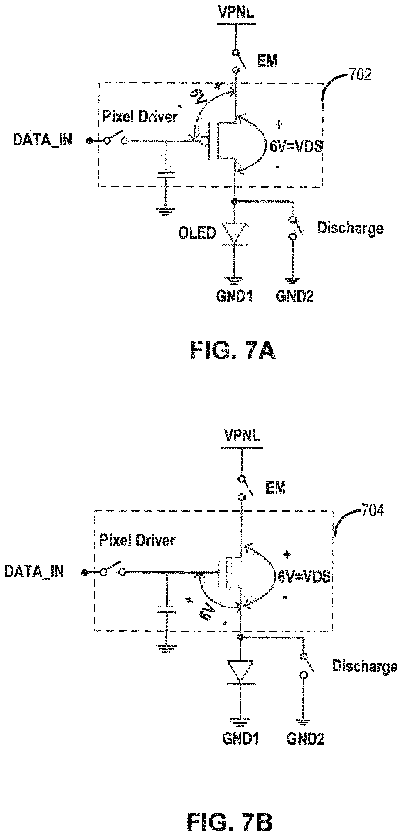

FIGs. 7A and 7B are circuit diagrams of pixel circuits for driving a light emitting element. FIG. 7A illustrates a p-type transistor-based pixel driver 702. Pixel driver 702 is a current mode driver based on a p-type driving transistor. The maximum voltage drop across the light emitting element is the same as the drain-source voltage V_{DS}, e.g., 6V between the power source VPNL and the ground GND1 (i.e., the voltage drop across the driving transistor). When the p-type driving transistor is turned-off, the voltage drop across the light emitting element is very close to 0. Thus, the light emitting element can be turned-off completely to achieve a very high contrast ratio. However, as the maximum voltage drop across the light emitting element is the same as the drain-source voltage of the driving transistor, the light emitting element may not use the tandem structure (multiple-diode stack) to increase its brightness. The increased number of diodes in the light emitting element can increase the maximum voltage drop when the light emitting element is turned-on (e.g., at the highest brightness), which may exceed the withstand voltage of the p-type driving transistor. For example, the voltage drop of a double-diode stack light emitting element may be between 5V to 9V, and the voltage drop of a triple-diode stack light emitting element may be between 8V to 12V.

FIG. 7B illustrates an n-type transistor-based pixel driver 704. Pixel driver 704 is a voltage mode driver (source follower) based on an n-type driving transistor. Different from pixel driver 702, the voltage drop across the light emitting element in FIG. 7B is not limited by the withstand voltage of the n-type driving transistor and may be increased by reducing the voltage of ground GND1. Thus, pixel driver 704 can support the tandem-type light emitting elements by driving the light emitting element with high voltage drop using the n-type driving transistor having low withstand voltage. However, the light emitting element driven by pixel driver 704 cannot be completely turned-off (e.g., still having leakage current) as the voltage drop across the light emitting element cannot become 0. Thus, the contrast ratio may be reduced.

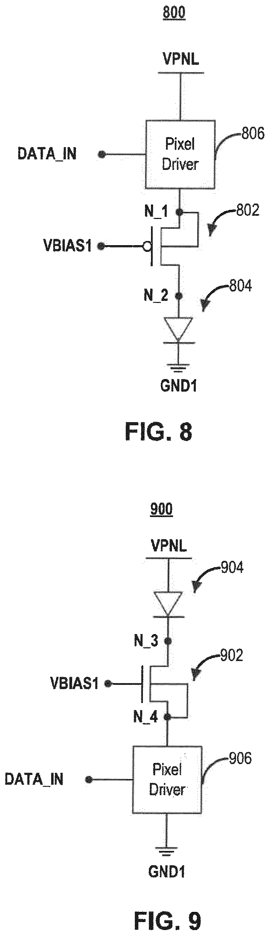

FIG. 8 is a circuit diagram of an exemplary pixel circuit 800 having a bridge transistor 802 for driving a light emitting element 804 in accordance with an embodiment. Light emitting element 804 may be an OLED or a micro-LED. Pixel circuit 800 includes a pixel driver 806 and bridge transistor 802 coupled to each other. Pixel driver 806 is configured to receive a data signal DATA_IN from source driving circuit 204 via a corresponding source line. Pixel driver 806 is further configured to drive light emitting element 804 based on the data signal. Bridge transistor 802 may be used as a voltage booster to increase the overall withstand voltage of pixel driver 806. Bridge transistor 802 in this embodiment is a p-type transistor having a gate terminal, a source terminal, a drain terminal, and a body terminal. The gate terminal of bridge transistor 802 receives a first bias signal V_{BIAS1} from, for example, any on-panel driving circuit described in FIG. 2 or control logic 104. The source terminal of bridge transistor 802 is coupled to pixel driver 806 (at node N_1). The drain terminal of bridge transistor 802 is coupled to a terminal of light emitting element 804 (at node N_2). In this embodiment, as bridge transistor 802 is a p-type transistor, the drain terminal is coupled to the cathode of light emitting element 804. The body terminal of bridge transistor 802 is coupled to the source terminal of bridge transistor 802. That is, the body and source terminals of bridge transistor 802 are coupled together to prevent the drain-body voltage V_{DB} from exceeding the withstand voltage to cause junction break-down. The drain-body voltage V_{DB} is thus the same as the drain-source voltage V_{DS}, e.g., 6V.

The first bias signal controls the voltage at the source terminal (at node N_1). The voltage at the source terminal V_{N_1} is the summation of the voltage of the first bias signal V_{BIAS1} and the gate-source voltage V_{GS} of bridge transistor 802 (V_{N_1} = V_{BIAS1} + V_{GS}). When light emitting element 804 is turned-off (without current passing through), the voltage drop across light emitting element 804 is at the minimum value. The minimum voltage drop across bridge transistor 802 is 0 when bridge transistor 802 is turned-off. At this time, turning off bridge transistor 802 (V_{GS} = 0) can cause the voltage at the source terminal V_{N_1} to become the same as the first bias signal V_{BIAS1} (V_{N_1} = V_{BIAS1}). Bridge transistor 802 and the driving transistor of pixel driver 806 share the remaining voltage drop between the power source VPNL and the ground GND1, thereby reducing the voltage drop across the driving transistor of pixel driver 806. In some embodiments, the first bias signal may control the voltage at the source terminal to be a midpoint voltage when light emitting element 804 is turned-off. That is, the drain-source voltage of the driving transistor of pixel driver 806 may be the same as the drain-source voltage of bridge transistor 802 as controlled by the first bias signal.

On the other hand, when light emitting element 804 is fully turned-on (i.e., at the highest brightness), the voltage drop across light emitting element 804 is at the maximum value. In this situation, bridge transistor 802 is turned-on and thus, light emitting element 804 does not suffer from performance degrade due to the extra voltage drop across bridge transistor 802. Accordingly, the first bias signal can control the voltage drop distribution between the driving transistor of pixel driver 806 and bridge transistor 802. The first bias signal can also control the off-state current (leakage current) when light emitting element 804 is turned-off.

FIG. 9 is a circuit diagram of another exemplary pixel circuit 900 having a bridge transistor 902 for driving a light emitting element 904 in accordance with an embodiment. Light emitting element 904 may be an OLED or a micro-LED. Pixel circuit 900 includes a pixel driver 906 and bridge transistor 902 coupled to each other. Pixel driver 906 is configured to receive a data signal DATA_IN from source driving circuit 204 via a corresponding source line. Pixel driver 906 is further configured to drive light emitting element 904 based on the data signal. Bridge transistor 902 may be used as a voltage booster to increase the overall withstand voltage of pixel driver 906. Bridge transistor 902 in this embodiment is an n-type transistor having a gate terminal, a source terminal, a drain terminal, and a body terminal. The gate terminal of bridge transistor 902 receives a first bias signal V_{BIAS1} from, for example, any on-panel driving circuit described in FIG. 2 or control logic 104. The source terminal of bridge transistor 902 is coupled to pixel driver 906 (at node N_4). The drain terminal of bridge transistor 902 is coupled to a terminal of light emitting element 904 (at node N_3). In this embodiment, as bridge transistor 902 is an n-type transistor, the drain terminal is coupled to the anode of light emitting element 904. The body terminal of bridge transistor 902 is coupled to the source terminal of bridge transistor 902. That is, the body and source terminals of bridge transistor 902 are coupled together to prevent the drain-body voltage V_{DB} from exceeding the withstand voltage to cause junction break-down. The drain-body voltage V_{DB} is thus the same as the drain-source voltage V_{DS}, e.g., 6V.

The first bias signal controls the voltage at the source terminal (at node N_4). The voltage at the source terminal V_{N_4} is the summation of the voltage of the first bias signal V_{BIAS1} and the gate-source voltage V_{GS} of bridge transistor 902 (V_{N_1} = V_{BIAS1} + V_{GS}). When light emitting element 904 is turned-off (without current passing through), the voltage drop across light emitting element 904 is at the minimum value. The minimum voltage drop across bridge transistor 902 is 0 when bridge transistor 902 is turned-off. At this time, turning off bridge transistor 902 (V_{GS} = 0) can cause the voltage at the source terminal V_{N_4} to become the same as the first bias signal V_{BIAS1} (V_{N_1} = V_{BIAS1}). Bridge transistor 902 and the driving transistor of pixel driver 906 share the remaining voltage drop between the power source VPNL and the ground GND1, thereby reducing the voltage drop across the driving transistor of pixel driver 906. In some embodiments, the first bias signal may control the voltage at the source terminal to be a midpoint voltage when light emitting element 904 is turned-off. That is, the drain-source voltage of the driving transistor of pixel driver 906 may be the same as the drain-source voltage of bridge transistor 902 as controlled by the first bias signal.

On the other hand, when light emitting element 904 is fully turned-on (i.e., at the highest brightness), the voltage drop across light emitting element 904 is at the maximum value. In this situation, bridge transistor 902 is turned-on and thus, light emitting element 904 does not suffer from performance degrade due to the extra voltage drop across bridge transistor 902. Accordingly, the first bias signal can control the voltage drop distribution between the driving transistor of pixel driver 906 and bridge transistor 902. The first bias signal can also control the off-state current (leakage current) when light emitting element 904 is turned-off.

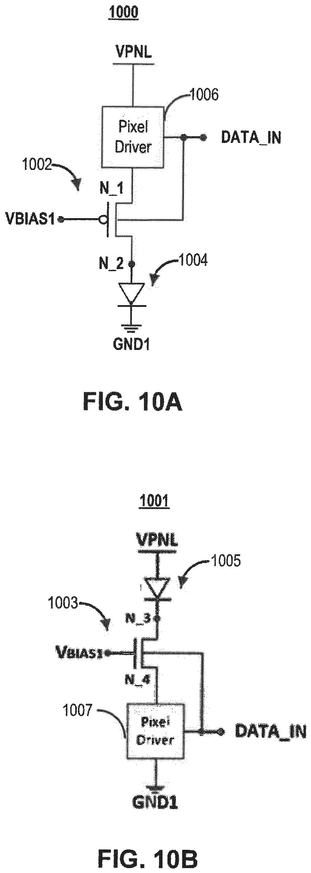

FIG. 10A is a circuit diagram of still another exemplary pixel circuit 1000 having a bridge transistor 1002 for driving a light emitting element 1004 in accordance with an embodiment. Pixel circuit 1000 is similar to pixel circuit 800 except that the body terminal of bridge transistor 1002 receives the data signal DATA_IN. That is, instead of coupling to the source terminal of bridge transistor 1002, the body terminal of bridge transistor 1002 can be coupled to a terminal of a pixel driver 1006 that receives the data signal. In this manner, pixel circuit 1000 can also prevent the drain-body voltage V_{DB} from exceeding the withstand voltage to cause junction break-down.

FIG. 10B is a circuit diagram of yet another exemplary pixel circuit 1001 having a bridge transistor 1003 for driving a light emitting element 1005 in accordance with an embodiment. Pixel circuit 1001 is similar to pixel circuit 900 except that the body terminal of bridge transistor 1003 receives the data signal DATA_IN. That is, instead of coupling to the source terminal of bridge transistor 1003, the body terminal of bridge transistor 1003 can be coupled to a terminal of a pixel driver 1007 that receives the data signal. In this manner, pixel circuit 1001 can also prevent the drain-body voltage V_{DB} from exceeding the withstand voltage to cause junction break-down.

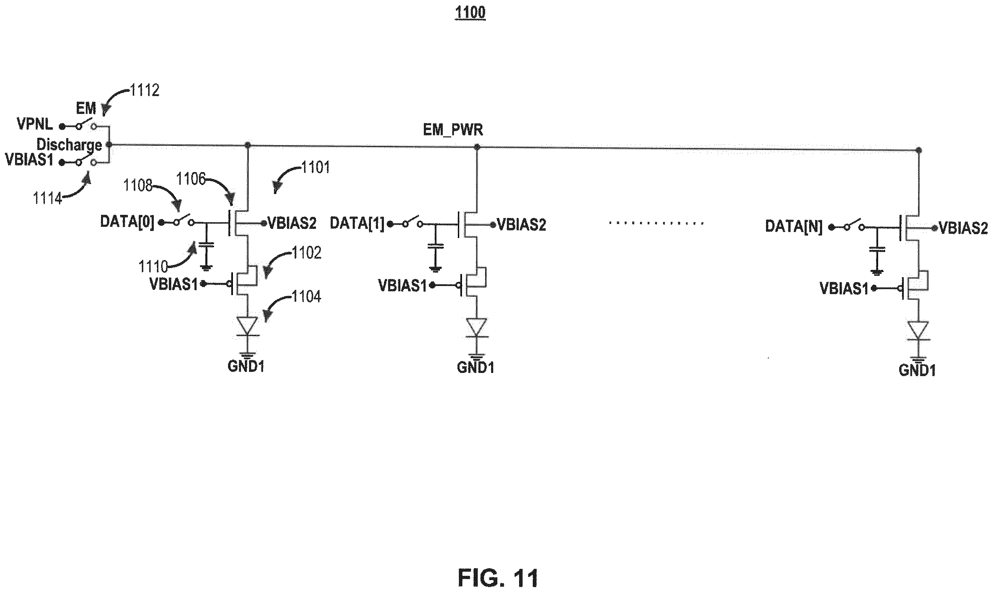

FIG. 11 is a circuit diagram of an exemplary circuit 1100 having global emission/discharge control and bridge transistors for driving light emitting elements in accordance with an embodiment. Circuit 1100 includes a plurality of pixel circuits, each of which is configured to drive one of a plurality of light emitting elements arranged in the same row. Taking pixel circuit 1101 as a representative example, it includes a bridge transistor 1102 coupled to the cathode of a light emitting element 1104. The details of bridge transistor 1102 are described above with respect to FIGs. 8 and 10 and will not be repeated again.

Pixel circuit 1101 also includes a pixel driver having a driving transistor 1106, a switch 1108 (e.g., a switching transistor), and a capacitor 1110 (e.g., a storage transistor). Driving transistor 1106 includes a source terminal, a drain terminal, a gate terminal, and a body terminal. In this embodiment, driving transistor 1106 is an n-type transistor, and its source terminal is coupled to the source terminal of bridge transistor 1102. The body terminal of driving transistor 1106 receives a second bias signal V_{BIAS2} that is different from the voltage of ground GND1. In some embodiments, the voltage of the second bias signal received by the body terminal of driving transistor 1106 may be the same as the voltage of the first bias signal V_{BIAS1} received by the body terminal of bridge transistor 1102. It is understood that driving transistor 1106 can be a p-type transistor with its drain terminal coupled to the source terminal of bridge transistor 1102, according to some embodiments. Capacitor 1110 includes a terminal coupled to the gate terminal of driving transistor 1106. Switch 1108 includes a first terminal receiving a corresponding data signal DATA[0] from source driving circuit 204 via a source line and a second terminal coupled to capacitor 1110 and the gate terminal of driving transistor 1106. Switch 1108 may include one or more transistors configured to, in response to a scan signal, charge capacitor 1110 to a voltage based on the data signal, so that the gate terminal of driving transistor 1106 is biased based on the voltage charged to capacitor 1110.

For each of the pixel circuits in circuit 1100, the switches of the pixel drivers receive the same scan signal from gate driving circuit 202 via the same scan line. In some embodiments, the gate terminals of the bridge transistors may receive the same first bias signal V_{BIAS1}, and the body terminals of the driving transistors may receive the same second bias signal V_{BIAS2}. The body terminal of each bridge transistor is individually coupled to its own source terminal, e.g., having a separate well, or coupled to the terminal of the switch that receives the data signal, to achieve the maximum withstand voltage and void junction break-down.

As shown in FIG. 11, circuit 1100 also includes a light emission controller 1112 and a discharge controller 1114. Light emission controller 1112 is coupled to the power source VPNL and the pixel drivers of each pixel circuit (at common node EM_PWR). That is, light emission controller 1112 can achieve global light emission control for all the light emitting elements in the same row as shown in FIG. 11. Light emission controller 1112 is configured to, in response to a global light emission signal, simultaneously control light emission of the plurality of light emitting elements in the same row. The light emission signal may be provided via a corresponding emission line from light emission driving circuit 206. In some embodiments, light emission controller 1112 may include one or more transistors acting as a switch controlled by the global light emission signal.

In this embodiment, discharge controller 1114 is coupled to the pixel drivers of each pixel circuit (at common node EM_PWR) and a terminal receiving the first bias signal V_{BIAS1}. That is, discharge controller 1114 can achieve global discharge of all the light emitting elements in the same row as sown in FIG. 11 to a voltage that is the same as the voltage of the first bias signal. As a result, the global discharge can also set the gate-source voltages V_{GS} of all the bridge transistors to 0 to turn off all the light emitting elements. Discharge controller 1114 is configured to, in response to a global discharge signal, simultaneously control discharge of the plurality of light emitting elements in the same row. Discharge controller 1114 may be configured to simultaneously control discharge of the plurality of light emitting elements to a voltage of the first bias signal. In some embodiments, discharge controller 1114 may include one or more transistor acting as a switch controlled by the global discharge signal.

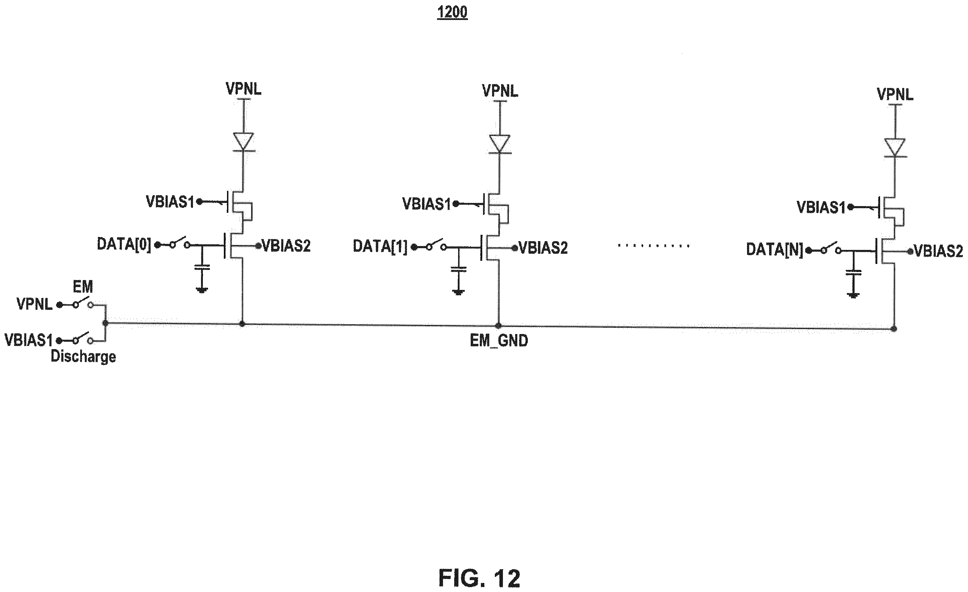

FIG. 12 is a circuit diagram of an exemplary circuit 1200 having global emission/discharge control and bridge transistors for driving light emitting elements in accordance with an embodiment. Circuit 1200 is similar to circuit 1100 with exceptions described below. In each pixel circuit, the bridge transistor is an n-type transistor having a drain terminal coupled to the anode of the light emitting element. The body terminal of the bridge transistor can be coupled to the source terminal of the bridge transistor or receive the data signal as described above with respect to FIGs. 9 and 10. In each pixel circuit, the driving transistor of the pixel driver is an n-type transistor having a drain terminal coupled to the source terminal of the bridge transistor. It is understood that in some embodiments, the driving transistor of the pixel driver may be a p-type transistor having a source terminal coupled to the source terminal of the bridge transistor. Each of the global light emission controller and discharger controller is coupled to the pixel drivers of all the light emitting elements in the same row (at common node EM_GND).

Circuits 1100 and 1200 described above in FIGs. 11 and 12 combine the global light emission and discharge control and the isolation device for voltage boosting (e.g., the bridge transistors) to achieve light emitting elements with high driving voltage, high contrast ratio, and high display resolution.

Also, integrated circuit design systems (e.g. work stations) are known that create wafers with integrated circuits based on executable instructions stored on a computer-readable medium such as but not limited to CDROM, RAM, other forms of ROM, hard drives, distributed memory, etc. The instructions may be represented by any suitable language such as but not limited to hardware descriptor language (HDL), Verilog or other suitable language. As such, the logic, units, and circuits described herein may also be produced as integrated circuits by such systems using the computer-readable medium with instructions stored therein.

For example, an integrated circuit with the aforedescribed logic, units, and circuits may be created using such integrated circuit fabrication systems. The computer-readable medium stores instructions executable by one or more integrated circuit design systems that causes the one or more integrated circuit design systems to design an integrated circuit. In one example, the designed integrated circuit includes a pixel driver and a bridge transistor. he pixel driver is configured to receive a data signal and drive a light emitting element based on the data signal. The bridge transistor includes a gate terminal receiving a first bias signal, a source terminal coupled to the pixel driver, a drain terminal coupled to a terminal of the light emitting element, and a body terminal coupled to the source terminal or receiving the data signal. The first bias signal controls a voltage at the source terminal.

In another example, the designed integrated circuit includes a plurality of pixel circuits and a discharge controller. Each of the plurality of pixel circuits is configured to drive one of a plurality of light emitting elements arranged in a same row and includes a pixel driver and a bridge transistor. The pixel driver is configured to receive a data signal and drive the corresponding light emitting element based on the data signal. The bridge transistor includes a gate terminal receiving a same first bias signal, a source terminal coupled to the pixel driver, a drain terminal coupled to a terminal of the light emitting element, and a body terminal coupled to the source terminal or receiving the data signal. The first bias signal controls a voltage at the source terminal. The discharge controller is coupled to the pixel drivers of each of the plurality of pixel circuits and is configured to, in response to a global discharge signal, simultaneously control discharge of the plurality of light emitting elements in the same row.

In still another example, the designed integrated circuit includes a plurality of pixel circuits, a discharge controller, and a light emission controller. Each of the plurality of pixel circuits is configured to drive one of a plurality of light emitting elements arranged in a same row and includes a pixel driver. The pixel driver is configured to receive a data signal and drive the corresponding light emitting element based on the data signal. The discharge controller is coupled to the pixel drivers of each of the plurality of pixel circuits and configured to, in response to a global discharge signal, simultaneously control discharge of the plurality of light emitting elements in the same row. The light emission controller is coupled to a power source and the pixel drivers of each of the plurality of pixel circuits and configured to, in response to a global light emission signal, simultaneously control light emission of the plurality of light emitting elements in the same row.

It is to be appreciated that the Detailed Description section, and not the Summary and Abstract sections, is intended to be used to interpret the claims. The Summary and Abstract sections may set forth one or more but not all exemplary embodiments of the present disclosure as contemplated by the inventor(s), and thus, are not intended to limit the present disclosure or the appended claims in any way.

The breadth and scope of the present disclosure should not be limited by any of the above-described exemplary embodiments, but should be defined only in accordance with the following claims.

## Claims

1. A display device (102) comprising a plurality of pixel circuits (1000, 1001) and a plurality of light emitting elements (1004, 1005),
wherein each pixel circuit (1000,1001) is configured to drive a light emitting element (1004, 1005), each pixel circuit comprising a pixel driver (1006, 1007), and a bridge transistor (1002, 1003), wherein the pixel driver (1006, 1007) is configured to receive a data signal via a corresponding source line and drive a corresponding light emitting element (1004; 1005) based on the data signal;
wherein the bridge transistor comprises a gate terminal receiving a first bias signal, a source terminal connected to the pixel driver (1006; 1007), a drain terminal connected to a terminal of the light emitting element (1004; 1005), and a body terminal connected to the source line to receive the data signal,
wherein the first bias signal controls a voltage at the source terminal of the bridge transistor, wherein the gate terminals of the bridge transistors arranged in a same row of pixel circuits receive a same first bias signal (VBIAS1),
wherein the display device is configured to supply data signals to the corresponding source lines and first bias signals to the gate terminals of the corresponding plurality of bridge transistors.

2. The display device (102) of claim 1, wherein the pixel driver (1006; 1007) comprises:
a driving transistor comprising a source terminal or a drain terminal coupled to the source terminal of the bridge transistor (1002; 1003), a body terminal receiving a second bias signal, and a gate terminal;
a capacitor comprising a terminal coupled to the gate terminal of the driving transistor; and
a switch configured to, in response to a scan signal, charge the capacitor to a voltage based on the data signal, so that the gate terminal of the driving transistor is biased based on the voltage charged to the capacitor,
wherein a plurality of body terminals of the driving transistors arranged in the same of pixel circuits receive a same second bias signal.

3. The display device (102) of claim 1 or 2, wherein the first bias signal controls the voltage at the source terminal to be a midpoint voltage when the light emitting element (1004; 1005) is turned off; and/or
wherein the light emitting element (1004; 1005) is an organic light emitting diode, OLED, or a micro-LED.

4. The display device (102) of any one of claims 1 to 3, wherein the bridge transistor (1002; 1003) is a p-type transistor, and the terminal of the light emitting element (1004; 1005) is an anode; or
wherein the bridge transistor (1002; 1003) is an n-type transistor, and the terminal of the light emitting element (1004; 1005) is a cathode.

5. The display device (102) of any one of claims 2 to 4, wherein a voltage of the first bias signal is the same as a voltage of the second bias signal.

## Patentansprüche

1. Anzeigevorrichtung (102), die eine Mehrzahl von Pixelschaltkreisen (1000, 1001) und eine Mehrzahl von lichtemittierenden Elementen (1004, 1005) umfasst,
wobei jeder Pixelschaltkreis (1000,1001) zum Ansteuern eines lichtemittierenden Elements (1004, 1005) ausgebildet ist, wobei jeder Pixelschaltkreis einen Pixeltreiber (1006, 1007) und einen Brückentransistor (1002, 1003) umfasst,
wobei der Pixeltreiber (1006, 1007) zum Empfangen eines Datensignals über eine entsprechende Quellenleitung und zum Ansteuern eines entsprechenden lichtemittierenden Elements (1004; 1005) auf der Basis des Datensignals ausgebildet ist;
wobei der Brückentransistor einen Gateanschluss, der ein erstes Vorspannungssignal empfängt, einen Sourceanschluss, der mit dem Pixeltreiber (1006; 1007) verbunden ist, einen Drainanschluss, der mit einem Anschluss des lichtemittierenden Elements (1004; 1005) verbunden ist, und einen Substratanschluss, der mit der Quellenleitung zum Erhalten des Datensignals verbunden ist, umfasst,
wobei das erste Vorspannungssignal eine Spannung an dem Sourceanschluss des Brückentransistors steuert,
wobei die Gateanschlüsse der Brückentransistoren, die in der gleichen Zeile von Pixelschaltkreisen angeordnet sind, das gleiche erste Vorspannungssignal (VBIAS1) erhalten, wobei die Anzeigevorrichtung zum Zuführen von Datensignalen zu den entsprechenden Quellenleitungen und von ersten Vorspannungssignalen zu den Gateanschlüssen der entsprechenden Mehrzahl von Brückentransistoren ausgebildet ist.

2. Anzeigevorrichtung (102) nach Anspruch 1, wobei der Pixeltreiber (1006; 1007) umfasst:
einen Treibertransistor, der einen Sourceanschluss oder einen Drainanschluss, der mit dem Sourceanschluss des Brückentransistors (1002; 1003) gekoppelt ist, einen Substratanschluss, der ein zweites Vorspannungssignal erhält, und einen Gateanschluss umfasst;
einen Kondensator, der einen Anschluss umfasst, der mit dem Gateanschluss des Treibertransistors gekoppelt ist; und
einen Schalter, der, als Reaktion auf ein Abtastsignal, zum Aufladen des Kondensators auf eine Spannung auf der Basis des Datensignals ausgebildet ist, so dass der Gateanschluss des Treibertransistors auf der Basis der Spannung, mit welcher der Kondensator aufgeladen worden ist, unter Vorspannung gesetzt wird,
wobei eine Mehrzahl von Substratanschlüssen der Treibertransistoren, die in der gleichen Zeile von Pixelschaltkreisen angeordnet sind, das gleiche zweite Vorspannungssignal erhält.

3. Anzeigevorrichtung (102) nach Anspruch 1 oder 2, wobei das erste Vorspannungssignal die Spannung an dem Sourceanschluss auf eine Mittelpunktspannung steuert, wenn das lichtemittierende Element (1004; 1005) ausgeschaltet wird; und/oder wobei das lichtemittierende Element (1004; 1005) eine organische Leuchtdiode, OLED, oder eine Mikro-LED ist.

4. Anzeigevorrichtung (102) nach einem der Ansprüche 1 bis 3, wobei der Brückentransistor (1002; 1003) ein Transistor des p-Typs ist und der Anschluss des lichtemittierenden Elements (1004; 1005) eine Anode ist; oder wobei der Brückentransistor (1002; 1003) ein Transistor des n-Typs ist und der Anschluss des lichtemittierenden Elements (1004; 1005) eine Kathode ist.

5. Anzeigevorrichtung (102) nach einem der Ansprüche 2 bis 4, wobei eine Spannung des ersten Vorspannungssignals mit einer Spannung des zweiten Vorspannungssignals identisch ist.

## Revendications

1. Un dispositif d'affichage (102) comprenant une pluralité de circuits de pixels (1000, 1001) et une pluralité d'éléments émetteurs de lumière (1004, 1005),
sachant que chaque circuit de pixels (1000, 1001) est configuré pour piloter un élément émetteur de lumière (1004, 1005), chaque circuit de pixels comprenant un pilote de pixels (1006, 1007), et un transistor en pont (1002, 1003),
sachant que le pilote de pixel (1006, 1007) est configuré pour recevoir un signal de données via une ligne source correspondante, et pour piloter un élément émetteur de lumière (1004 ; 1005) correspondant sur la base du signal de données ;
sachant que le transistor en pont comprend une borne de grille recevant un premier signal de polarisation, une borne de source connectée au pilote de pixel (1006 ; 1007), une borne de drain connectée à une borne de l'élément émetteur de lumière (1004 ; 1005), et une borne de corps connectée à la ligne de source pour recevoir le signal de données,
sachant que le premier signal de polarisation commande une tension au niveau de la borne de source du transistor en pont,
sachant que les bornes de grille des transistors en pont agencées dans une même rangée de circuits de pixels reçoivent un même premier signal de polarisation (VBIAS1),
sachant que le dispositif d'affichage est configuré pour fournir des signaux de données aux lignes de source correspondantes et des premiers signaux de polarisation aux bornes de grille de la pluralité correspondante de transistors en pont.

2. Le dispositif d'affichage (102) d'après la revendication 1, sachant que le pilote de pixel (1006 ; 1007) comprend :
un transistor de pilotage comprenant une borne de source ou une borne de drain couplée à la borne de source du transistor en pont (1002 ; 1003), une borne de corps recevant un deuxième signal de polarisation, et une borne de grille ;
un condensateur comprenant une borne couplée à la borne de grille du transistor de pilotage ; et
un commutateur configuré pour, en réponse à un signal de balayage, charger le condensateur à une tension sur la base du signal de données, de manière que la borne de grille du transistor de pilotage soit polarisée sur la base de la tension chargée sur le condensateur,
sachant qu'une pluralité de bornes de corps des transistors de pilotage agencés dans le même des circuits de pixels reçoivent un même deuxième signal de polarisation.

3. Le dispositif d'affichage (102) d'après la revendication 1 ou 2, sachant que le premier signal de polarisation commande la tension au niveau de la borne de source pour qu'elle soit une tension médiane *(midpoint voltage)* lorsque l'élément émetteur de lumière (1004 ; 1005) est éteint ; et/ou
sachant que l'élément émetteur de lumière (1004 ; 1005) est une diode électroluminescente organique, OLED, ou une micro-LED.

4. Le dispositif d'affichage (102) d'après l'une quelconque des revendications de 1 à 3, sachant que le transistor en pont (1002 ; 1003) est un transistor de type p, et que la borne de l'élément émetteur de lumière (1004 ; 1005) est une anode ; ou
sachant que le transistor en pont (1002 ; 1003) est un transistor de type n, et que la borne de l'élément émetteur de lumière (1004 ; 1005) est une cathode.

5. Le dispositif d'affichage (102) d'après l'une quelconque des revendications de 2 à 4, sachant qu'une tension du premier signal de polarisation est la même qu'une tension du deuxième signal de polarisation.
